# EUROPÄISCHE PATENTSCHRIFT

(11) **EP 3 197 418 B1**
(45) Veröffentlichungstag und Bekanntmachung des Hinweises auf die Patenterteilung: **27.02.2019**
(21) Anmeldenummer: 15747782.9
(22) Anmeldetag: 31.07.2015
(51) Int. Cl.: A61J 3/07, G01R 27/26, B65B 69/00

(54) **KAPSELFÜLLMASCHINE**
CAPSULE FILLING MACHINE
MACHINE DE REMPLISSAGE DE CAPSULES

(30) Priorität: 26.09.2014 DE 102014219576
(43) Veröffentlichungstag der Anmeldung: 02.08.2017
(73) Patentinhaber: Robert Bosch GmbH, 70442 Stuttgart (DE)
(72) Erfinder: RUNFT, Werner, 71364 Winnenden (DE); FRANCK, Thomas, 73547 Lorch-Weitmars (DE); SCHLIPF, Jens, 71691 Freiberg A. N. (DE)
(86) Internationale Anmeldenummer: PCT/EP2015/067622
(87) Internationale Veröffentlichungsnummer: WO 2016/045838

(56) Entgegenhaltungen:
- US-A- 4 964 262
- US-A1- 2008 134 629
- US-B1- 6 499 279

## Beschreibung

### Stand der Technik

Die vorliegende Erfindung betrifft eine Kapselfüllmaschine, insbesondere für den pharmazeutischen Bereich, welche eine Kapsel mit einem Kapseloberteil und einem Kapselunterteil befüllt.

Kapselfüllmaschinen sind aus dem Stand der Technik in unterschiedlichen Ausgestaltungen bekannt. Beispielsweise zeigt die EP 2 389 919 A2 eine Kapselfüllmaschine, bei der eine Kapsel an einem Förderrad an einer Vielzahl von Stationen befüllt wird. Hierbei werden noch weitere Handhabungen wie Öffnen der Kapseln, Wiegen der Kapseln usw. vorgenommen. Diese Kapselfüllmaschine hat sich grundsätzlich bewährt, jedoch besteht am Markt oft das Bedürfnis, dass zusätzliche Handhabungsstationen an derartige Förderräder angeordnet werden sollen. Aufgrund der angestrebten Kompaktheit der Kapselfüllmaschine ist jedoch die Anzahl der zur Verfügung stehenden Stationsplätze begrenzt. Im pharmazeutischen Bereich ergeben sich hier ferner erhöhte Anforderungen bezüglich einer Prozesskontrolle, sodass eine Kontrolle mehrfach am Förderrad vorgenommen werden muss, wodurch die freie Anzahl von verfügbaren Stationen sich weiter reduziert. Häufig müssen jedoch auch mehrfach Füllungen der Kapseln vorgenommen werden, wobei für jede Füllung eine separate Station notwendig ist, da bei den Mehrfach-Füllungen z. B. verschiedene Produkte gemischt werden müssen. Aus der US 2008/0134629 A1 ist eine Kapselfüllmaschine gemäß dem Oberbegriff des Anspruchs 1 bekannt.

### Offenbarung der Erfindung

Die erfindungsgemäße Kapselfüllmaschine mit den Merkmalen des Anspruchs 1 weist demgegenüber den Vorteil auf, dass eine Anzahl zur Verfügung stehender Stationsplätze erhöht werden kann. Dies wird erfindungsgemäß dadurch erreicht, dass wenigstens zwei Handhabungsschritte an einer gemeinsamen Arbeitsstation zusammengeführt werden. Dadurch ergibt sich wenigstens ein freiwerdender Stationsplatz, welcher für andere Handhabungsschritte genutzt werden kann. Erfindungsgemäß wird dabei eine Kapseltrennvorrichtung, welche die Kapseln in ein Kapseloberteil und ein Kapselunterteil trennt, und eine Kapselanwesenheitsvorrichtung, welche überprüft, ob überhaupt eine Kapsel richtig in einer Aufnahme oder dergleichen aufgenommen wurde, an einer gemeinsamen Station integriert. Dadurch kann ferner die Kompaktheit der Kapselfüllmaschine weiter verbessert werden. Dabei umfasst die Kapseltrennvorrichtung eine Kapseloberteilaufnahme, eine Kapselunterteilaufnahme sowie einen Unterdruckerzeuger. Der Unterdruckerzeuger erzeugt einen Unterdruck oder ein Vakuum, welches mit der Kapselunterteilaufnahme in Verbindung steht. Dadurch kann das Kapselunterteil vom Kapseloberteil getrennt werden, da die Kapseloberteile üblicherweise lediglich auf die Kapselunterteile aufgesteckt sind. Das Kapseloberteil wird dabei in der Kapseloberteilaufnahme gehalten. Weiter umfasst die Kapselanwesenheitsvorrichtung einen Sensor zur Erfassung einer Anwesenheit der Kapsel. Besonders bevorzugt erfasst der Sensor dabei, ob ein Kapselunterteil vorhanden ist. Dies ist deshalb wichtig, da die Kapselunterteile nach dem Trennvorgang vom Kapseloberteil von oben befüllt werden. Sollte kein Kapselunterteil vorhanden sein, würde die Füllung in die Maschine fallen und hier zu erheblichen Verschmutzungen und Beeinträchtigungen führen. Weiterhin ergeben sich Kosten für das verlorene Produkt. Weiter umfasst die Kapseltrennvorrichtung einen Trennstift, welcher unterhalb der Kapselunterteilaufnahme angeordnet ist. Der Sensor ist dabei an einem zur Kapselunterteilaufnahme gerichteten Ende des Trennstifts angeordnet.

Die Unteransprüche zeigen bevorzugte Weiterbildungen der Erfindung.

Für einen besonders kompakten Aufbau ist die Kapselanwesenheitsvorrichtung vorzugsweise unter der Kapseltrennvorrichtung angeordnet. Besonders bevorzugt ist die Kapselanwesenheitsvorrichtung unter dem Kapselunterteil angeordnet.

Besonders bevorzugt ist der Trennstift dabei linear bewegbar. Somit kann ein sicherer Trennvorgang zwischen Kapseloberteil und Kapselunterteil ermöglicht werden.

Gemäß einer weiteren bevorzugten Ausgestaltung der Erfindung ist der Sensor zur Erfassung einer Anwesenheit der Kapsel ein kapazitiver Sensor. Der kapazitive Sensor ist besonders bevorzugt an einem freien Ende des hohlen Trennstifts angeordnet, welches zur Kapselunterteilaufnahme gerichtet ist. Der kapazitive Sensor ist dabei besonders bevorzugt ein kapazitiver Näherungssensor.

Weiter bevorzugt umfasst die Kapselfüllmaschine einen Drehteller, wobei die Vielzahl von separaten Stationen entlang des Umfangs des Drehtellers angeordnet sind. Besonders bevorzugt sind dabei zwölf Stationen vorgesehen.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: eine schematische Draufsicht einer Kapselfüllmaschine gemäß einem bevorzugten Ausführungsbeispiel der Erfindung;
- Figur 2: eine schematische Schnittansicht einer kombinierten Kapseltrenn- und Kapselanwesenheitsstation in einem Ausgangszustand;
- Figur 3: eine schematische Schnittansicht der Station von Fig. 2 in einer Abholposition des Kapselunterteils,
- Figur 4: eine schematische Schnittansicht der Station von Fig. 2 in einer Trennvorgangsposition von Kapseloberteil und Kapselunterteil sowie einer Detektionsposition des Kapselunterteils und
- Figur 5: eine schematische Schnittansicht der Station von Fig. 2, nachdem ein Trennvorgang von Kapseloberteil, und Kapselunterteil abgeschossen ist.

### Bevorzugte Ausführungsformen der Erfindung

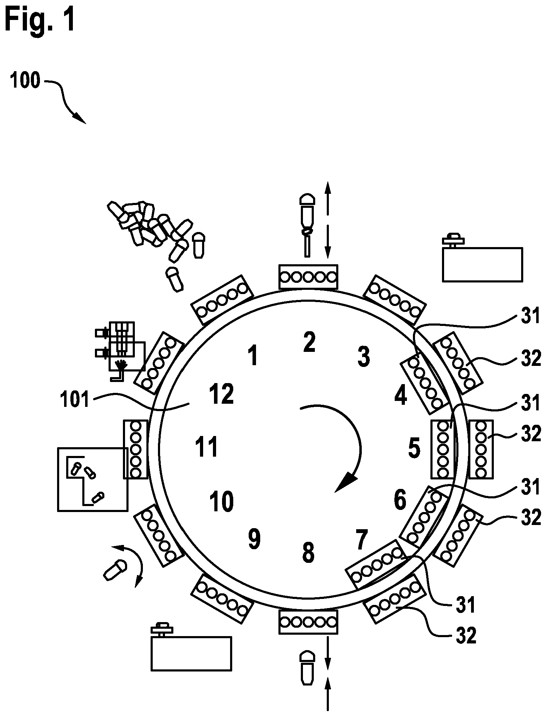

Nachfolgend wird unter Bezugnahme auf die Figuren 1 bis 5 eine Kapselfüllmaschine 1 gemäß einem bevorzugten Ausführungsbeispiel der Erfindung im Detail beschrieben.

Wie aus Fig. 1 ersichtlich ist, umfasst die Kapselfüllmaschine 100 einen rotierenden Drehteller 101, an dessen Umfang zwölf Stationen angeordnet sind, welche durch die Zahlen 1 bis 12 gekennzeichnet sind. Die Kapseln werden dabei in die Station 1 zugeführt und an der Station 2 getrennt, wobei das Kapseloberteil vom Kapselunterteil getrennt wird. Ferner wird in der Station 2 eine Anwesenheitsüberprüfung der Kapseln vorgenommen. Wie aus Fig. 1 ersichtlich ist, sind die Kapseln in Kapselaufnahmen 103 angeordnet, was später noch im Detail beschrieben wird. Bevorzugt wird an der Station getrennt, an der auch zugeführt wird. Es kann jedoch auch später getrennt werden.

An der Station 3 wird die leere, nicht getrennte Kapsel gewogen und beim Wiedereinsetzen wird das Kapseloberteil vom Kapselunterteil getrennt und auf Anwesenheit geprüft, sodass das Kapselunterteil nach oben offen ist, um einen Füllvorgang durchzuführen.

Der Füllvorgang wird dann in der Station 4, 5, 6 und 7 durchgeführt, wobei an jeder Station jeweils z. B. ein anderes Füllgut befüllt wird oder unterschiedliche Füllmengen eines gleichen Füllgutes befüllt werden.

An der Station 8 werden die beiden Kapselhälften wieder verschlossen und an der Station 9 nochmals gewogen. Hierbei wird an der Station 9 festgestellt, ob die Füllung der Kapseln ausreichend ist, was insbesondere bei Medikamenten von Bedeutung ist.

Die Station 10 ist eine Schlechtkapsel-Ausscheidungsstation, an welcher beispielsweise beschädigte Kapseln oder nicht richtig befüllte Kapseln entfernt werden. An der Station 11 werden die richtig befüllten Kapseln aus der Kapselfüllmaschine ausgeworfen und die Station 12 ist eine Reinigungsstation, bevor wieder neue, leere Kapseln an der Station 1 aufgenommen werden.

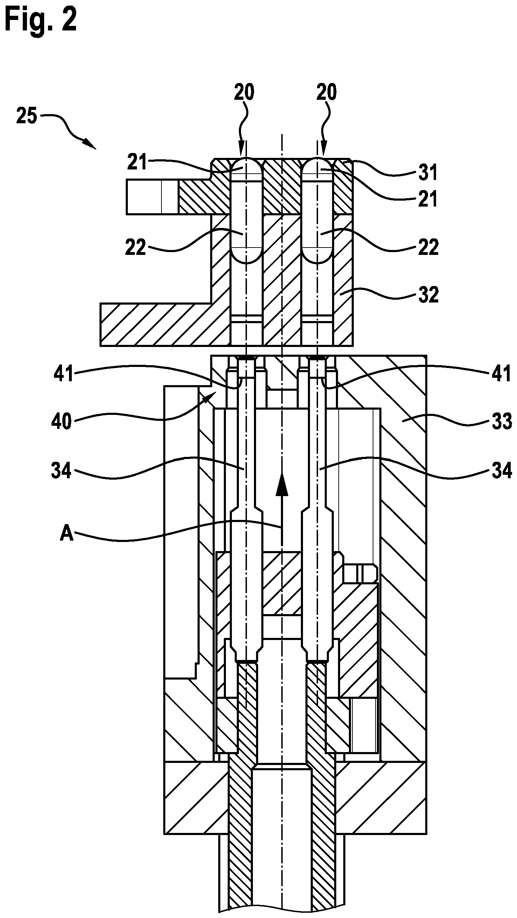

Erfindungsgemäß ist nun an den Stationen 1 und 2 oder an Station 3 eine kombinierte Kapseltrenn- und Kapselanwesenheitsstation vorgesehen. Hierbei werden zwei Funktionen, nämlich die Trennung der Kapseln in das Kapseloberteil und das Kapselunterteil sowie eine Anwesenheitskontrolle an einer Station vereinigt. In den Fig. 2 bis 5 ist dabei die Funktionsweise der kombinierten Station 2 dargestellt.

Fig. 2 zeigt dabei den Ausgangszustand der kombinierten Kapseltrenn- und Kapselanwesenheitsstation 25. Die Kapseln 20 sind noch geschlossen, d. h. das Kapseloberteil 21 ist auf das Kapselunterteil 22 aufgesteckt. Das Kapseloberteil 21 wird dabei in der Kapseloberteilaufnahme 31 gehalten. Das Kapselunterteil 22 ist in einer Kapselunterteilaufnahme 32 aufgenommen.

Wie aus Fig. 2 ersichtlich ist, ist das Kapselunterteil 22 dabei teilweise auch noch in der Kapseloberteilaufnahme 31 angeordnet. In einem ersten Schritt wird nun ein Unterdruck mittels des Unterdruckerzeugers 33 erzeugt. Die Kapseltrennvorrichtung umfasst ferner noch einen Trennstift 34, welcher einen kapazitiven Sensor 41 umfasst. Der Trennstift 34 ist linear bewegbar, was mittels eines nicht gezeigten Antriebs realisiert wird. Wie aus Fig. 2 ersichtlich ist, wird der Trennstift 34 dabei linear in Richtung des Pfeils A zur Kapselaufnahme bewegt.

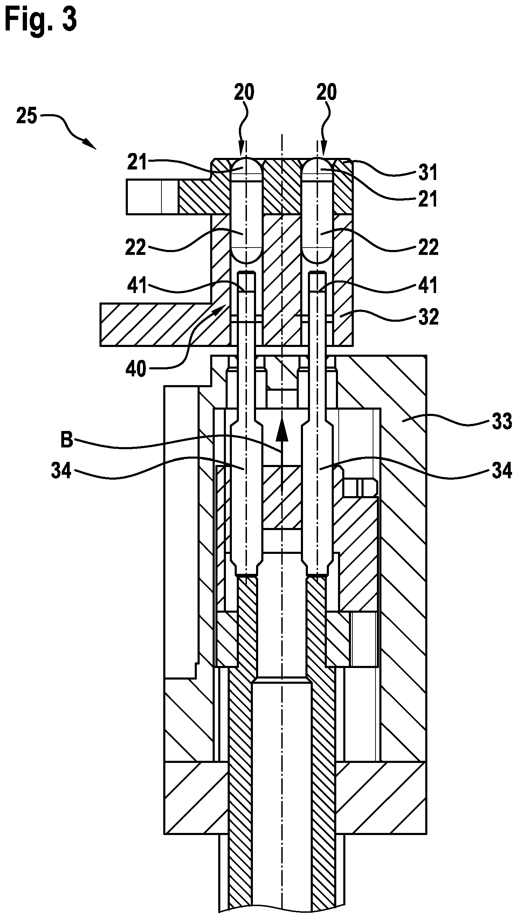

In Fig. 3 ist der Unterdruckerzeuger 33 auf die Kapselunterteilaufnahme 32 aufgesetzt, damit der Unterdruck auch im Bereich unterhalb des Kapselunterteils 22 vorhanden ist. Der Trennstift 34 wird weiter in Richtung des Pfeils B linear bewegt, so lange, bis der Trennstift 34 mit dem Kapselunterteil 22 in Kontakt kommt.

Ferner ist eine Kapselanwesenheitsvorrichtung 40 vorgesehen, welche einen kapazitiven Sensor 41 umfasst. Der kapazitive Sensor 41 ist dabei an einem freien Ende des Trennstifts 34, welches zum Unterteil 22 gerichtet ist, angeordnet. Sobald der Trennstift 34 das Kapselunterteil 22 berührt, erfasst der kapazitive Sensor 41 diese Berührung, sodass sichergestellt werden kann, dass ein Kapselunterteil in der Kapselunterteilaufnahme 32 angeordnet ist.

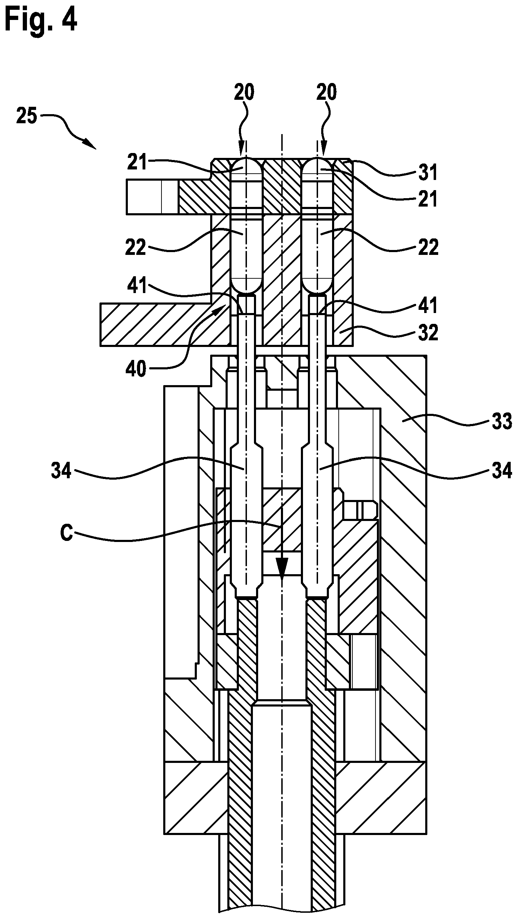

Der mittels des Unterdruckerzeugers 33 erzeugte Unterdruck herrscht dabei im Hohlraum unterhalb des Kapselunterteils 22. Dadurch wird das Kapselunterteil 22 angesaugt, sodass sich das Kapselunterteil 22 vom Kapseloberteil 21 löst. Dies ist in Fig. 4 durch den Pfeil C angedeutet. Das Kapseloberteil 21 wird dabei fest in der Kapseloberteilaufnahme 31 gehalten.

Fig. 4 zeigt dabei gerade den Zustand, an welchem das Kapselunterteil 22 vom Kapseloberteil 21 getrennt ist.

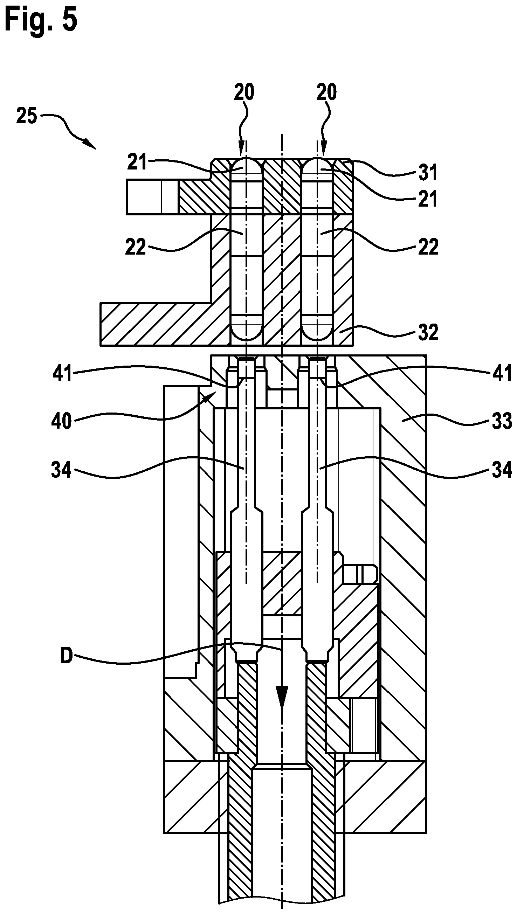

Wie aus Fig. 5 ersichtlich ist, wird das Kapselunterteil 22 noch eine kurze Wegstrecke nach unten bewegt, sodass eine sichere Trennung zwischen Kapselunterteil und Kapseloberteil erfolgt ist. Anschließend wird der Unterdruckerzeuger 33 wieder von der Kapselunterteilaufnahme 32 abgezogen und der Trennstift 34 in Richtung des Pfeils D weiter in den Unterdruckerzeuger 33 eingezogen.

Die ungetrennte Kapsel wird zunächst an der Station 3 gewogen und nach dem Wiedereinsetzen getrennt und das Kapselunterteil auf Anwesenheit geprüft. In den Stationen 4 bis 7 wird das Kapselunterteil mit verschiedenen Produkten gefüllt. In der Station 4 wird dabei noch die Kapseloberteilaufnahme 31 von der Kapselunterteilaufnahme 32 getrennt, um eine einfache Befüllung des Kapselunterteils zu ermöglichen.

Es sei angemerkt, dass in den Fig. 2 bis 5 jeweils zwei Kapseln 20 sowie zwei Trennstifte 34 dargestellt sind. Üblicherweise werden eine Vielzahl von Kapseln, bevorzugt in einer zweireihigen Anordnung, in einer Kapselaufnahme vorgesehen. Entsprechend ist dann auch die notwendige Anzahl von Trennstiften 34 vorzusehen.

Somit kann erfindungsgemäß eine Funktion der Kapseltrennung und eine Funktion der Kapselanwesenheitsüberprüfung in eine gemeinsame Station integriert werden. Die Kapselanwesenheitsstation ist dabei in die Kapseltrennstation integriert. Hierdurch ergibt sich ein sehr kompakter Aufbau, welcher insbesondere in radialer Richtung des Drehtellers 101 keinen zusätzlichen Bauraum benötigt. Die Kapselanwesenheitsvorrichtung 40 ist dabei in den Trennstift 34 integriert, sodass die Anwesenheit eines Kapselunterteils einfach und sicher detektiert werden kann.

Die Sensoren 41 sind vorzugsweise kapazitive Näherungssensoren. Es können jedoch auch andere Arten von Sensoren verwendet werden.

Weiterhin kann das Erkennen eines nicht vorhandenen Kapselunterteils auch dazu verwendet werden, dass eine gezielte Nichtbefüllung des fehlenden Kapselunterteils in den nachfolgenden Stationen erfolgt. Hierdurch ist es insbesondere möglich, die durchgehende Taktfrequenz der Kapselfüllmaschine 100 aufrecht zu erhalten.

Es sei ferner angemerkt, dass statt der vorhergehend dargestellten doppelten Funktionsweise des Trennens der Kapsel und Detektierens der Kapselunterteile in dieser Station auch ausschließlich eine Kapselunterteiltastung eingesetzt werden kann. Hierzu befinden sich die Kapselunterteile 22 bereits in der Kapselunterteilaufnahme 32 und werden von den Trennstiften 34 nur kurz berührt, um die Anwesenheit zu prüfen.

## Patentansprüche

1. Kapselfüllmaschine zur Befüllung einer ein Kapseloberteil (21) und ein Kapselunterteil (22) umfassenden Kapsel (20), umfassend
- eine Vielzahl von separaten Stationen zur Handhabung der Kapseln (20) und
- eine Kapseltrennvorrichtung und eine Kapselanwesenheitsvorrichtung (40) zur Überprüfung der Anwesenheit einer Kapsel,
- wobei die Kapseltrennvorrichtung und die Kapselanwesenheitsvorrichtung (40) in einer gemeinsamen Station (2) integriert sind, **dadurch gekennzeichnet, dass** die Kapseltrennvorrichtung eine Kapseloberteilaufnahme (31), eine Kapselunterteilaufnahme (32) und einen Unterdruckerzeuger (33) umfasst, wobei der Unterdruckerzeuger (33) mit der Kapselunterteilaufnahme (32) in Verbindung steht, wobei die Kapselanwesenheitsvorrichtung (40) einen Sensor (41) zur Erfassung einer Anwesenheit einer Kapsel in der Kapselunterteilaufnahme (32) umfasst,wobei die Kapseltrennvorrichtung wenigstens einen Trennstift (34) umfasst, welcher unterhalb der Kapselunterteilaufnahme (32) angeordnet ist, und
wobei der Sensor (41) an einem zur Kapselunterteilaufnahme (32) gerichteten Ende des Trennstift (34) angeordnet ist.

2. Kapselfüllmaschine nach Anspruch 1, **dadurch gekennzeichnet, dass** der Sensor (41) ein kapazitiver Sensor, insbesondere ein kapazitiver Näherungssensor, ist.

3. Kapselfüllmaschine nach Anspruch 1, **dadurch gekennzeichnet, dass** der Trennstift (34) linear bewegbar ist.

4. Kapselfüllmaschine nach einem der vorhergehenden Ansprüche, ferner umfassend einen Drehteller (101), wobei die Vielzahl von Stationen entlang des Umfangs des Drehtellers (101) angeordnet sind.

5. Kapselfüllmaschine nach einem der vorhergehenden Ansprüche, **dadurch gekennzeichnet, dass** der Unterdruckerzeuger (33) relativ zur Kapselunterteilaufnahme (32) linear bewegbar ist.

## Claims

1. Capsule-filling machine for filling a capsule (20) comprising an upper capsule part (21) and a lower capsule part (22), the capsule-filling machine comprising
- a multiplicity of separate stations for handling the capsules (20) and
- a capsule-separating device and a capsule-presence device (40) for checking the presence of a capsule,
- wherein the capsule-separating device and the capsule-presence device (40) are integrated in a common station (2), **characterized in that** the capsule-separating device comprises an upper-capsule-part holder (31), a lower-capsule-part holder (32) and a vacuum generator (33), wherein the vacuum generator" (33) is in connection with the lower-capsule-part holder (32), wherein the capsule-presence device (40) comprises a sensor (41) for sensing the presence of a capsule in the lower-capsule-part holder (32), wherein the capsule-separating device comprises at least one separating pin (34), which is arranged beneath the lower-capsule-part holder (32), and wherein the sensor (41) is arranged at an end of the separating pin (34) which is directed towards the lower-capsule-part holder (32).

2. Capsule-filling machine according to Claim 1, **characterized in that** the sensor (41) is a capacitive sensor, in particular a capacitive proximity sensor.

3. Capsule-filling machine according to Claim 1, **characterized in that** the separating pin (34) can be moved linearly.

4. Capsule-filling machine according to one of the preceding claims, also comprising a turntable (101), wherein the multiplicity of stations are arranged along the circumference of the turntable (101).

5. Capsule-filling machine according to one of the preceding claims, **characterized in that** the vacuum generator (33) can be moved linearly relative to the lower-capsule-part holder (32).

## Revendications

1. Machine de remplissage de capsules pour le remplissage d'une capsule (20) comprenant une partie supérieure de capsule (21) et une partie inférieure de capsule (22), comprenant
- une pluralité de postes séparés pour manipuler les capsules (20) et
- un dispositif de séparation de capsules et un dispositif de présence de capsules (40) pour vérifier la présence d'une capsule,
- le dispositif de séparation de capsules et le dispositif de présence de capsules (40) étant intégrés dans un poste commun (2), **caractérisée en ce que** le dispositif de séparation de capsules comprend un logement de partie supérieure de capsule (31), un logement de partie inférieure de capsule (32) et un générateur de vide (33), le générateur de vide (33) étant en liaison avec le logement de partie inférieure de capsule (32), le dispositif de présence de capsules (40) comprenant un capteur (41) pour détecter une présence d'une capsule dans le logement de partie inférieure de capsule (32), le dispositif de séparation de capsules comprenant au moins une goupille de séparation (34) qui est disposée sous le logement de partie inférieure de capsule (32), et
le capteur (41) étant disposé au niveau d'une extrémité de la goupille de séparation (34) orientée vers le logement de partie inférieure de capsule (32).

2. Machine de remplissage de capsules selon la revendication 1, **caractérisée en ce que** le capteur (41) est un capteur capacitif, en particulier un capteur capacitif de proximité.

3. Machine de remplissage de capsules selon la revendication 1, **caractérisée en ce que** la goupille de séparation (34) est déplaçable linéairement.

4. Machine de remplissage de capsules selon l'une quelconque des revendications précédentes, comprenant en outre un plateau tournant (101), la pluralité de postes étant disposés le long de la périphérie du plateau tournant (101).

5. Machine de remplissage de capsules selon l'une quelconque des revendications précédentes, **caractérisée en ce que** le générateur de vide (33) peut être déplacé linéairement par rapport au logement de partie inférieure de capsule (32).
